# EUROPEAN PATENT SPECIFICATION

(11) **EP 4 243 581 B1**
(45) Date of publication and mention of the grant of the patent: **29.10.2025**
(21) Application number: 22746104.3
(22) Date of filing: 10.01.2022
(51) Int. Cl.: H05K 5/06, H05K 1/14, H04M 1/02, H01Q 1/24, H05K 3/32, H04M 1/18, H05K 1/18, H01Q 1/52

(54) **ELECTRONIC APPARATUS COMPRISING WATERPROOF STRUCTURE**
ELEKTRONISCHE VORRICHTUNG MIT WASSERDICHTER STRUKTUR
APPAREIL ÉLECTRONIQUE COMPRENANT UNE STRUCTURE ÉTANCHE À L'EAU

(30) Priority: 28.01.2021 KR 20210012217
(43) Date of publication of application: 13.09.2023
(73) Proprietor: Samsung Electronics Co., Ltd., Suwon-si, Gyeonggi-do 16677 (KR)
(72) Inventor: CHO, Sunggun, Suwon-si, Gyeonggi-do 16677 (KR); PAK, Hwamok, Suwon-si, Gyeonggi-do 16677 (KR); AN, Minyee, Suwon-si, Gyeonggi-do 16677 (KR); LEE, Geuna, Suwon-si, Gyeonggi-do 16677 (KR); LEE, Dongik, Suwon-si, Gyeonggi-do 16677 (KR); LIM, Jinho, Suwon-si, Gyeonggi-do 16677 (KR); JUNG, Minsu, Suwon-si, Gyeonggi-do 16677 (KR); CHOI, Wonhee, Suwon-si, Gyeonggi-do 16677 (KR)
(74) Representative: Gulde & Partner
(86) International application number: PCT/KR2022/000348
(87) International publication number: WO 2022/164075

(56) References cited:
- WO-A1-2020/036408
- KR-A- 20170 040 082
- KR-A- 20180 013 436
- KR-A- 20180 026 191
- KR-A- 20200 101 791
- KR-A- 20210 001 050

## Description

### [Technical Field]

Embodiments disclosed in the disclosure relate to an electronic device including a waterproof structure

### [Background Art]

An electronic device may display an image through a display disposed in a housing. A plurality of pixels for displaying an image may be disposed in the display. The plurality of pixels may receive data voltages and light emission signals for displaying an image from a display driver IC (DDI).

The electronic device may require a dust prevention/waterproof structure for securing a smooth operation and preventing foreign substances from being introduced thereinto. For example, an electronic device, such as a mobile communication terminal, an electronic note, or a tablet PC, which is used while being carried by a user, generally may be exposed to various operation environments. In spite of a change in an operation environment, the electronic device may be provided with various forms of dust-prevention/waterproof structures to secure a stable operation performance by preventing contaminations due to introduction of foreign substances.

WO 2020/036408 A1 discloses an electronic device including a waterproof structure. The electronic device includes a housing including a first plate oriented in a first direction, a second plate oriented in a second direction opposite to the first direction, and a side surface member surrounding a space between the first plate and the second plate, and a display panel disposed between the first plate and the second plate. The display panel includes a flat area including an active area configured to emit light toward the first plate, and a connection area extending from at least a partial area of one edge of the flat area and is disposed between the first plate and the second plate, a polarizing plate disposed on the flat area, and a filler member spaced apart from the connection area and disposed on the one edge of the flat area, wherein the one edge of the flat area includes a cut surface bent in a stepped shape in an area on which the filler member is disposed, and a part of the cut surface includes a shape in which a boundary of the display panel coincides with a boundary of the polarizing plate.

KR 2021 0001050 A discloses an electronic device including a sealing structure that implements a waterproof function while facilitating expansion of a display size.

KR 2017 0040082 A discloses a device comprising: a housing including a first surface, a second surface facing away from the first surface, and a side surface surrounding a space between the first surface and the second surface; An intermediate plate disposed between the first surface and the second surface of the housing and substantially parallel to the first surface and extending from the side and comprising at least one opening, A printed circuit board disposed between the plate and the second surface; a display disposed between the intermediate plate and the first surface, the display including a surface directed toward the second surface; and a hermetically and a seal member disposed between the surface of the display and the intermediate plate.

### [Disclosure]

### [Technical Problem]

The electronic device may interrupt introduction of moisture and foreign substances through a waterproof member disposed therein. However, a degree of freedom of design may be degraded due to interferences between at least one component (e.g., a speaker, a back cover waterproof member, an antenna, or a magnetic body) included in the electronic device and the waterproof member.

Various embodiments of the disclosure provide an electronic device including a waterproof member having an enhanced degree of freedom.

### [Technical Solution]

The present invention is defined by the appended set of claims. Preferred embodiments are defined by the dependent claims. According to an embodiment, an electronic device comprises a housing including a first side member and a second side member facing each other in a first direction, and a third side member and a fourth side member facing each other in a second direction that is different from the first direction, a display panel disposed in the housing, a conductive film connected to the display panel, a circuit board connected to the conductive film, a first waterproof member spaced apart from the circuit board, a second waterproof member facing the first waterproof member in the first direction, and disposed to be closer to the third side member and the fourth side member than to the conductive film, and a bonding waterproof member disposed between the first waterproof member and the second waterproof member, and facing a side surface of at least any one of the conductive film and the circuit board in the second direction.

According to an embodiment, the housing includes an injection hole disposed in an area corresponding to the bonding waterproof member.

According to an embodiment, the electronic device further comprises: a non-display module received in the housing, wherein the injection hole does not overlap the non-display module.

According to an embodiment, the non-display module includes at least any one of an antenna, a cover waterproof tape, and a segmentation part.

According to an embodiment, the electronic device further comprises: a first magnetic body received in the housing; and a second magnetic body received in the housing to face the first magnetic body, wherein the injection hole does not overlap at least any one of the first magnetic body and the second magnetic body.

According to an embodiment, the display panel includes a first area, a second area, and a bending area located between the first area and the second area, wherein the second area includes: a first inactive area extending from the bending area; and second inactive areas extending from opposite sides of the first inactive area, and wherein a width of the second area is larger than a width of the bending area.

According to an embodiment, the second waterproof member is disposed on surfaces of the first inactive area and the second inactive areas.

According to an embodiment, the electronic device further comprises: a third waterproof member disposed on opposite surfaces of the first inactive area and the second inactive areas, and wherein the first waterproof member is disposed between the first area and the housing, wherein the second waterproof member is disposed between the second area and the housing, and wherein the third waterproof member is disposed between the first area and the second area.

According to an embodiment, a plurality of signal lines are disposed in at least any one of the first inactive area and the second inactive area.

According to an embodiment, the second inactive areas are disposed to be closer to the second side member and the third side member than to the conductive film.

According to an embodiment, the second waterproof member overlaps the second inactive areas.

According to an embodiment, the first waterproof member is disposed to surround at least three surfaces of the circuit board, and the second waterproof member is disposed to surround at least one surface of the conductive film.

According to an embodiment, the first waterproof member includes: a first waterproof sealing member being parallel to the first side member and the second side member; and a second waterproof sealing member extending from the first waterproof sealing member toward the third side member, wherein the second waterproof member includes: a third waterproof sealing member being parallel to the first waterproof sealing member; and a fourth waterproof sealing member extending from the third waterproof sealing member toward the second waterproof sealing member.

According to an embodiment, a corner portion of the fourth waterproof sealing member faces a corner portion, at which the third side member and the fourth side member meet the second side member.

According to an embodiment, the conductive film is an anisotropic conductive film (ACF).

According to another embodiment, an electronic device may include a housing including a first side member and a second side member facing each other in a first direction, and a third side member and a fourth side member facing each other in a second direction that is different from the first direction, a display panel disposed in the housing, a conductive film connected to the display panel, a circuit board connected to the conductive film, a first waterproof member surrounding at least three surfaces of the circuit board and spaced apart from the circuit board, a second waterproof member surrounding at least one surface of the conductive film, facing the first waterproof member in the first direction, and disposed to be closer to the third side member and the fourth side member than to the conductive film, and a bonding waterproof member disposed between the first waterproof member and the second waterproof member, and facing a side surface of at least any one of the conductive film and the circuit board.

### [Advantageous Effects]

According to embodiments disclosed in the disclosure, the electronic device may secure a stable dust-prevention/waterproof performance by using at least one waterproof member.

Furthermore, according to embodiments disclosed in the disclosure, because the bonding waterproof member included in the plurality of waterproof members is disposed to reduce interferences with the components disposed in the housing, a degree of freedom of design may be enhanced.

In addition, according to embodiments disclosed in the disclosure, the bonding waterproof member may prevent damage to the display panel during a rework process by disposing the bonding waterproof member such that it is spaced apart from the signal lines.

In addition, various effects recognized directly or indirectly through the disclosure may be provided.

### [Description of Drawings]

FIG. 1 is a perspective view illustrating a front surface of an electronic device according to an embodiment.
FIG. 2 is a perspective view illustrating a rear surface of an electronic device illustrated in FIG. 1.
FIG. 3A is a perspective view illustrating a front surface of an electronic device including a waterproof member according to an embodiment, and FIG. 3B is a perspective view illustrating a rear surface of an electronic device including a waterproof member according to an embodiment.
FIG. 4 is a plan view illustrating a state, in which a display included in an electronic device according to an embodiment is bent.
FIG. 5 is a plan view illustrating before a display included in an electronic device according to an embodiment is bent.
FIG. 6 is a perspective view illustrating a display panel illustrated in FIG. 5 according to an embodiment.
FIG. 7A is a plan view illustrating a front surface of a display, to which a waterproof member is attached, according to an embodiment, and FIG. 7B is a plan view illustrating a rear surface of a display, to which a waterproof member is attached, according to an embodiment.
FIG. 8 is a view illustrating a display including a bonding waterproof member according to an embodiment.
FIGS. 9A and 9B are cross-sectional views illustrating an electronic device including a display, taken along line I-I' of FIG. 8, according to another embodiment.
FIG. 10A is a view illustrating an injection hole for forming a bonding waterproof member of an electronic device according to an embodiment, and FIG. 10B is a view illustrating a dispenser for forming a bonding waterproof member of an electronic device according to an embodiment.
FIGS. 11A and 11B are views illustrating at least one part disposed at one side end of a housing of an electronic device according to an embodiment.
FIG. 12 is a rear perspective view illustrating an unfolded state of a foldable electronic device according to an embodiment.
FIG. 13 is a cross-sectional view illustrating a folded state of an electronic device illustrated in FIG. 12 according to an embodiment.
FIG. 14 is a view illustrating a disposition relationship of a magnetic body and a bonding waterproof member illustrated in FIG. 13 according to an embodiment.
FIG. 15 is a view illustrating a disposition relationship of a flexible printed circuit board and a bonding waterproof member according to various embodiments.

In relation to a description of the drawings, the same or similar reference numerals may be used for the same or similar components.

### [Mode for Invention]

Hereinafter, various embodiments of the disclosure may be described with reference to accompanying drawings. Accordingly, those of ordinary skill in the art will recognize that modifications on the various embodiments described herein can be variously made without necessarily departing from the scope of the disclosure.

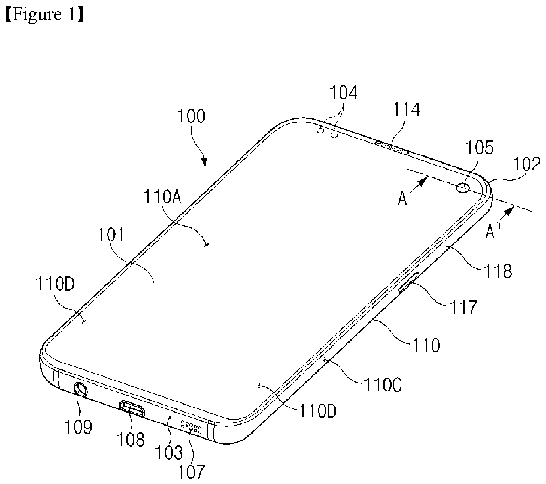

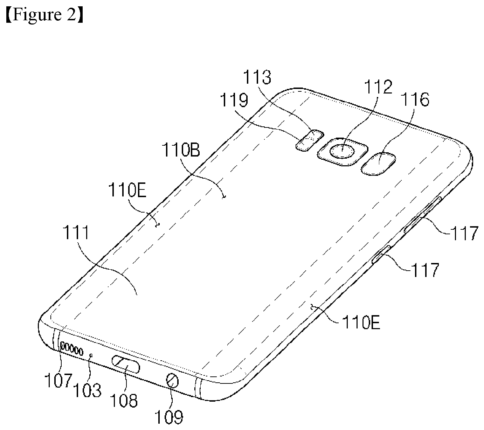

FIG. 1 is a front perspective view illustrating an electronic device according to an embodiment of the disclosure, and FIG. 2 is a rear perspective view of an electronic device according to an embodiment of the disclosure.

Referring to FIGS. 1 and 2, an electronic device 100 according to an embodiment may include a housing 110 including a first surface (e.g., a front surface) 100A, a second surface (e.g., a rear surface) 110B, and a side surface 110C that surrounds a space between the first surface 110A and the second surface 110B. In another embodiment (not illustrated), the housing may refer to a structure that defines a portion of the first surface 110A, the second surface 110B, and the side surface 110C of FIG. 1.

According to an embodiment, at least a portion of the first surface 110A may be formed by a substantially transparent front plate 102 (e.g., a glass plate including various coating layers or a polymer plate). The second surface 110B may be formed by a substantially opaque rear plate 111. The rear plate 111, for example, may be formed of coated or colored glass, ceramics, a polymer, a metal (e.g., aluminum, stainless steel (STS), or magnesium), or a combination of at least two thereof. The side surface 110C may be coupled to the front plate 102 and the rear plate 111, and may be formed by a side bezel structure 118 (or a "side member") including a metal and/or a polymer. In some embodiments, the rear plate 111 and the side bezel structure 118 may be integrally formed and include the same material (e.g., a metallic material such as aluminum).

In the illustrated embodiment, the front plate 102 may include first areas 110D that are curved from the first surface 110A toward the rear plate to extend seamlessly at opposite ends of a long edge of the front plate.

In the illustrated embodiment (see FIG. 1), the rear plate 111 may include second areas 110E that are curved from the second surface 110B toward the front plate to extend seamlessly at opposite ends of a long edge thereof. In another embodiment, the front plate 102 or the rear plate 111 may include only one of the first areas 110D and the second areas 110E. In another embodiment, the front plate 102 may not include the first areas and the second areas, but may include only a flat surface disposed in parallel to the second surface 110B. In embodiments, when viewed from a lateral side of the electronic device, the side bezel structure 118 may have a first thickness (or a width) on a side surface that includes neither the first areas 110D nor the second areas 110E, and may have a second thickness that is smaller than the first thickness on a side surface that includes the first areas or the second areas.

According to an embodiment, the electronic device 100 may include at least one of a display 101, an input device 103, sound output devices 107 and 114, sensor modules 104 and 119, camera modules 105, 112, and 113, a key input device 117, an indicator (not illustrated), and connectors 108 and 109. In some embodiments, the electronic device 100 may exclude at least one (e.g., the key input device 117 or an indicator) of the components or may additionally include another component.

For example, the display 101 may be viewed through an upper end part of the front plate 102. In some embodiments, at least a portion of the display 101 may be viewed through the front plate 102 that defines the first surface 110A and the first areas 110D of the side surface 110C. The display 101 may be disposed to be coupled to or adjacent to a pressure sensor that may measure an intensity (pressure) of a touch and/or a digitizer that detects a stylus pen of a magnetic field type. In some embodiments, at least a portion of the sensor modules 104 and 119 and/or at least a portion of the key input device 117 may be disposed in the first areas 110D and/or the second areas 110E.

The input device 103 may include a plurality of microphones that are disposed to detect a direction of a sound. The sound output devices 107 and 114 may include the speakers 107 and 114. The speakers 107 and 114 may include the external speaker 107 and the receiver 114 for voice communication. In another embodiment, the microphone 103, the speakers 107 and 114, and the connectors 108 and 109 may be disposed in a space of the electronic device 100, and may be exposed to an external environment through at least one hole formed in the housing 110. In another embodiment, the hole formed in the housing 110 may be used in common for the microphone 103 and the speakers 107 and 114. In another embodiment, the sound output devices 107 and 114 may include speakers (e.g., piezoelectric speakers) that are operated while the hole formed in the housing 110 is excluded.

The sensor modules 104 and 119 may generate electrical signals or data values corresponding to an operation state of an interior of the electronic device 100 or an external environmental state. For example, the sensor modules 104 and 119 may include the first sensor module 104 (e.g., a proximity sensor) disposed on the first surface 110A of the housing 110, a second sensor module (not illustrated) (e.g., a fingerprint sensor), and/or the third sensor module 119 (e.g., an HRM sensor) disposed on the second surface 110B of the housing 110. The fingerprint sensor may be disposed on the first surface 110A (e.g., a home key button 115) of the housing 110, in a partial area of the second surface 110B, or under the display 101. The electronic device 100 may further include sensor modules that are not illustrated, for example, at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or the illumination sensor 104.

The camera modules 105, 112, and 113 may include the first camera device 105 disposed on the first surface 110A of the electronic device 100, the second camera device 112 disposed on the second surface 110B, and/or the flash 113. The camera modules 105 and 112 may include one or a plurality of lenses, an image sensor, and/or an image signal processor. The flash 113, for example, may include a light emitting diode or a xenon lamp. In another embodiment, two or more lenses (a wide angle lens, an ultra-wide angle lens, or a telescopic lens) and image sensors may be disposed on one surface of the electronic device 100.

The key input device 117 may be disposed on the side surface 110C of the housing 110. In another embodiment, the electronic device 100 may not include some or all of the mentioned key input devices 117, and the key input devices 117 that are not included may be implemented in another form, such as a soft key, on the display 101. In another embodiment, the key input device 117 may be implemented by using a pressure sensor included in the display 101.

The indicator may be disposed on the first surface 110A of the housing 110. For example, the indicator may provide state information of the electronic device 100 in a form of light. In another embodiment, the light emitting element, for example, may provide a light source that interworks with an operation of the camera module 105. The indicator, for example, may include an LED, an IR LED, and a xenon lamp.

The connector holes 108 and 109 may include the first connector hole 108 that may accommodate a connector (for example, a USB connector) for transmitting and receiving electric power and/or data to and from an external electronic device, and/or the second connector hole (or an earphone jack) 109 that may accommodate a connector for transmitting and receiving an audio signal to and from an external electronic device.

The camera module 105 of the camera modules 105 and 112, the sensor module 104 of the sensor modules 104 and 119, or the indicator may be disposed to be viewed through the display 101. The sensor module 104 may be disposed to perform their functions while not being visually exposed through the front plate 102 in an interior space of the electronic device.

According to various embodiments, the electronic device 100 may include a waterproof structure for waterproof, in an interior thereof. For example, the waterproof structure may be disposed between the display 101 and the housing 110.

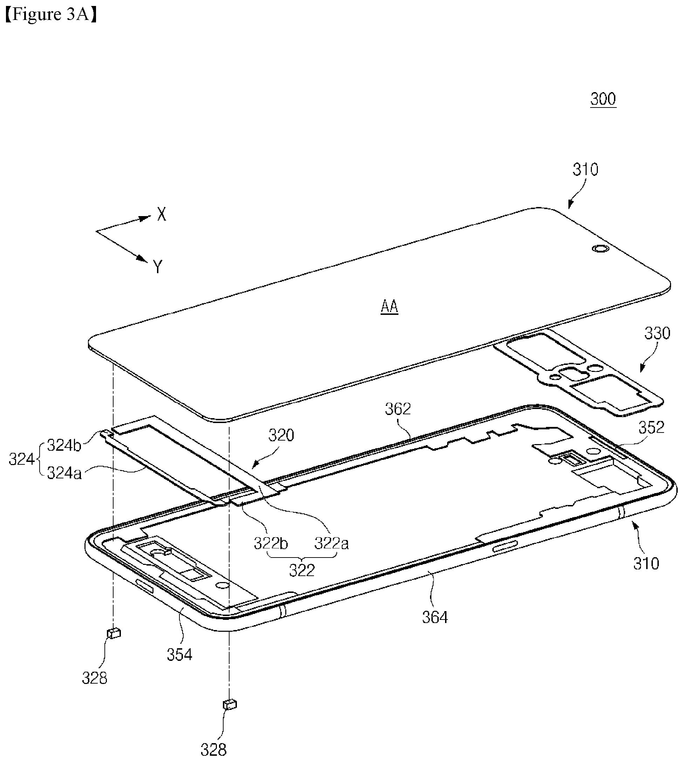

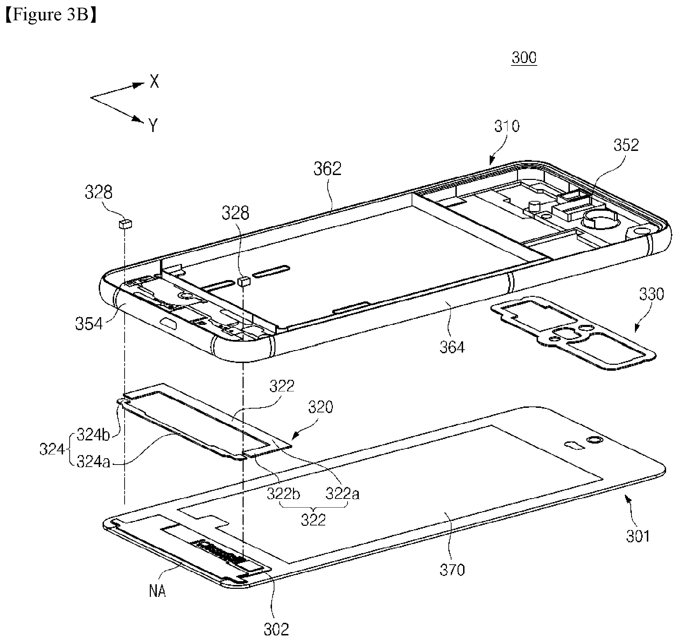

Hereinafter, referring to FIGS. 3A and 3B, an electronic device 300 according to an embodiment including the waterproof structure will be described.

FIGS. 3A and 3B are exploded perspective views of a housing 310, a display 301, and a plurality of waterproof members 320 and 330 included in the electronic device 300 according to an embodiment.

The housing 310 and the display 301 of FIGS. 3A and 3B may be at least partially similar to the housing 110 and the display 101 of FIG. 1 or may further include anther embodiment of the housing 110 and the display 101.

The housing 310 may include a side member that surrounds a side surface of the display 301. The side member may include a plurality of side members. For example, the side member may include first to fourth side members 352, 354, 362, and 364.

The first and second side members 352 and 354 may be disposed to extend in a second direction "Y" and face each other in a first direction "X" that is different from the second direction "Y". In various embodiments, the first direction "X" may cross the second direction "Y".

The third and fourth side members 362 and 364 may be disposed to extend in the first direction "X" and face each other in the second direction "Y" that is different from the first direction. The first and second side members 352 and 354 may be disposed between the third and fourth side members 362 and 364. The third and fourth side members 362 and 364 that extend in the first direction "X" and the first and second side members 352 and 354 that extend in the second direction "Y" meet each other to define a plurality of corner portions.

The housing 310 may include an interior space surrounded by the first to fourth side members 352, 354, 362, and 364. The circuit board, the battery, and the like may be accommodated in an interior space of the housing 310, and because the display 301 is mounted on a front surface of the housing 310, the housing 310 may finish an external appearance of the electronic device 300.

The display 301 may display an image by using a plurality of pixels. The display 301 may include an active area AA, in which an image is displayed, and an inactive area NA that is bent to a space between the housing 301 and a rear surface of the display 301. The display 301 may be bonded to a front surface of the housing 310 by using the waterproof members 320 and 330.

The waterproof members 330 and 320 may be disposed between the housing 310 and the display 301. The waterproof members 330 and 320 may include the upper end waterproof member 330 and the lower end waterproof member 320.

The upper end waterproof member 330 may be formed at an upper end (e.g., a proximate area of the side member 352) of the housing 310 to locate a portion of the display 301 at an upper end of the housing 310. Then, a receiver part (for example, the receiver for voice communication and the speaker of FIG. 2) for voice communication may be disposed at an upper end of the housing 310. The lower end waterproof member 320 may locate a portion of the display 301 at a lower end (e.g., a proximate area of the side member 354). Then, a printed circuit board 302, on which a processor, a memory, and/or an interface are mounted, may be disposed at a lower end of the housing 310.

The lower end waterproof member 320 may include first and second waterproof members 322 and 324, and a bonding waterproof member 328. The lower end waterproof member 320 may be disposed to surround the flexible circuit board 302. A peripheral portion of the flexible circuit board 302 may have a stepped area due to a thickness of the inactive area NA disposed at a portion of the rear surface of the display 301. Due to the stepped area, the lower end waterproof member 320 may be divided into the first and second waterproof members 322 and 324, and the bonding waterproof member 328 may be filled in the stepped area between the first and second waterproof members 322 and 324.

The first waterproof member 322 may be disposed between the flexible printed circuit board 302 and a battery 370. The first waterproof member 322 may include first and second waterproof sealing areas 322a and 322b to surround at least three surfaces of the flexible printed circuit board 302.

The first waterproof sealing area 322a may be disposed between the flexible printed circuit board 302 and the battery 370. The first waterproof sealing area 322a may be disposed in parallel to the first and second side members 352 and 354 of the housing 310.

The second waterproof sealing area 322b may extend from opposite sides of the first waterproof sealing area 322a toward the second side member 354 of the housing 310. The second waterproof sealing area 322b may be disposed to be parallel to the third and fourth side members 362 and 364 of the housing 310. A length of the second waterproof sealing area 322b may be smaller than a length of the first waterproof sealing area 322a.

The second waterproof member 324 may be disposed to be closer to the second side member 354 of the housing than to the first waterproof member 322. The second waterproof member 324 may include third and fourth waterproof sealing areas 324a and 324b.

The third waterproof sealing area 324a may be disposed between the flexible printed circuit board 302 and the second side member 354 of the housing 310. The third waterproof sealing area 324a may be disposed to face a side surface of the flexible printed circuit board 302. For example, the third waterproof sealing area 324a may be disposed to face a long side surface of the flexible printed circuit board 302.

The fourth waterproof sealing area 324b may extend from opposite sides of the third waterproof sealing area 324a toward the second waterproof sealing area 322b. The fourth waterproof sealing area 324b may be disposed to face the second waterproof sealing area 322b. For example, the fourth waterproof sealing area 324b may be disposed to face the second waterproof sealing area 322b in a direction that is parallel to the third and fourth side members 362 and 364 of the housing 310. A length of the fourth waterproof sealing area 324b may be smaller than a length of the third waterproof sealing area 324a and a length of the second waterproof sealing area 322b. A corner portion of the fourth waterproof sealing area 324b may be formed to face corner portions, at which the third and fourth side members 362 and 364 and the second side member 354 meet each other.

In an embodiment, the second waterproof member 324 may include only the third waterproof sealing area 324a without any fourth waterproof sealing area 324b. In this case, the third waterproof sealing area 324a may be disposed to face the second waterproof sealing area 322b in the first direction "X". A corner portion of the third waterproof sealing area 324a may be formed to face corner portions, at which the third and fourth side members 362 and 364 and the second side member 354 meet each other.

Because the bonding waterproof member 328 is disposed between the first and second waterproof members 322 and 324, the bonding waterproof member 328, and the first and second waterproof members 322 and 324 may be formed in a closed loop form that surrounds the flexible printed circuit board 302. Accordingly, because a waterproof and dust prevention path of the electronic device 300 may be provided with no aperture, a stable waterproof and dust prevention function may be provided.

According to various embodiments, the electronic device 300 may be a flexible electronic device, of which a partial area of the display 301 may be folded. In this case, the electronic device 300 may include a flexible display that is disposed in a space defined by the housing 310.

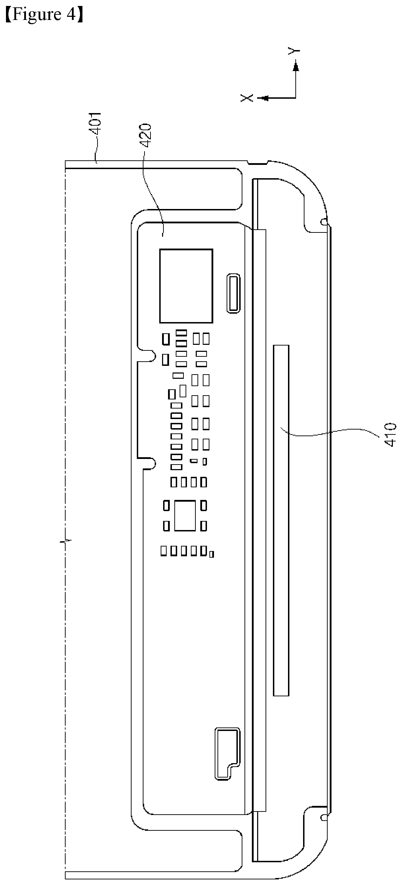

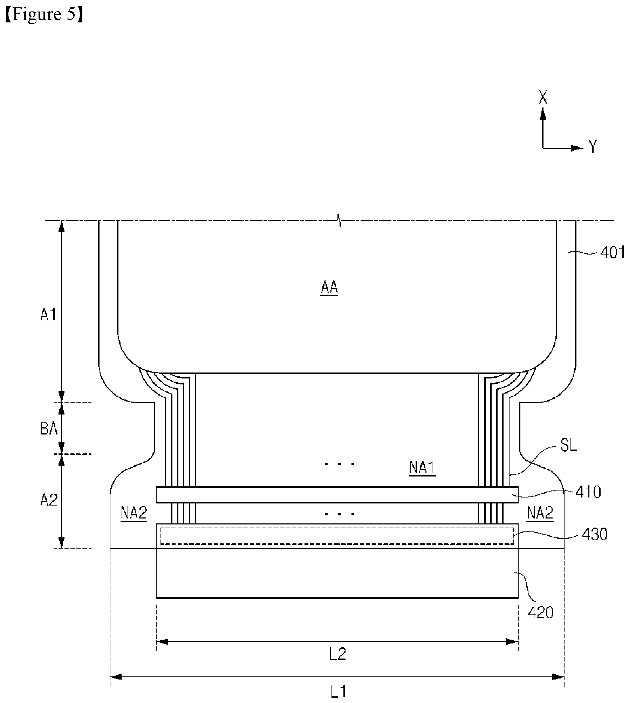

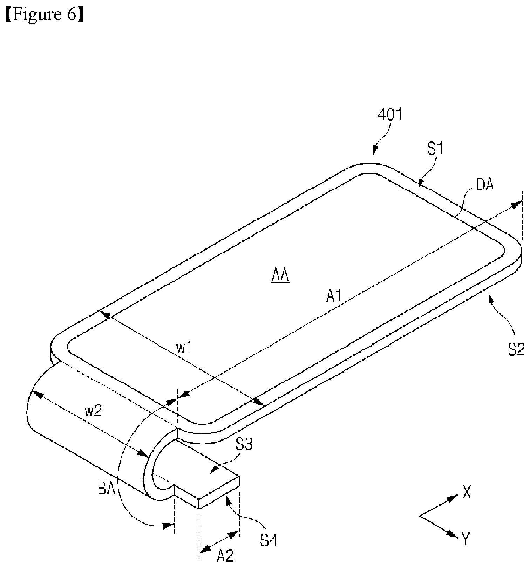

FIG. 4 is a plan view illustrating a state, in which the display included in the electronic device according to an embodiment is bent. FIG. 5 is a plan view illustrating before the display included in the electronic device according to an embodiment is bent. FIG. 6 is a perspective view illustrating a state, in which the display panel included in the electronic device according to an embodiment is bent.

Referring to FIGS. 4 to 6, the display according to an embodiment may include a display panel 401, a display driver integrated circuit (DDI) 410, and a flexible printed circuit board (FPCB) 420.

The display driver integrated circuit 410 may generate driving signals for driving the pixels disposed in the display panel 401 in correspondence to data and control signals, which are supplied from an outside. The driving signals generated by the display driver integrated circuit 410 may be supplied to the pixels disposed in the display panel 401.

Parts that are necessary for driving the display driver integrated circuit 410 may be mounted on the flexible printed circuit board 420. The flexible printed circuit board 420 may be electrically connected to the display driver integrated circuit 410 through a conductive film 430. The conductive film 430 may be an anisotropic conductive film (ACF).

The display panel 401, as illustrated in FIG. 6, may include first and second areas A1 and A2, and at least one bending area BA.

The bending area BA may be disposed between the first and second areas A1 and A2, and may be bent from the first area A1 to the rear surface of the electronic device while having a specific curvature. The first and second areas A1 and A2 may face each other while the bending area BA being interposed therebetween.

The first area A1 is an area, in which an image may be displayed, and may have an area that is larger than that of the second area A2. The first area A1 may include first and second surfaces S1 and S2 that face each other. The first surface S1 of the first area A1 may include the active area AA, in which an image is displayed by using at least one pixel. A width W1 of the first area A1 may be larger than a width W2 of the bending area BA.

The second area A2 is an area, in which no image may be displayed, and may have an area that is smaller than that of the first area A1. The second area A2 may include third and fourth surfaces S3 and S4 that face each other. The third surface S3 of the second area A2 may be disposed to face the second surface S2 of the first area A1. The DDI 410, the conductive film 430, and the FPCB 420 may be disposed on the fourth surface S4 of the second area A2.

A length L1 of the second area A2 may be formed to be larger than a length L2 of the conductive film 430 and the flexible printed circuit board 420. The second area A2 may include a first inactive area NA1 and a second inactive area NA2.

The first inactive area NA1 may be formed to extend from the bending area BA in the first direction "X". The first inactive area NA1, for example, may be formed to extend in a direction that is parallel to an extension direction of a signal line SL. Because the first inactive area NA1 includes an area that contacts the conductive film 430, at least one pixel disposed in the first area A1 and signal lines SL electrically connected to the conductive film 430 may be disposed.

The second inactive area NA2 may be formed to extend from the first inactive area NA1 in the second direction "Y". For example, the second inactive area NA2 may be formed to extend in a direction that crosses the signal line SL. The second inactive area NA2 may protrude further than the sides of the conductive film 430 and the flexible printed circuit board 420 to be disposed to be closer than the third and fourth side members 362 and 364 of the housing (e.g., the housing 310 of FIGS. 3A and 3B) than to the conductive film 430 and the flexible printed circuit board 420. The second inactive area NA2 may be an area that does not contact the conductive film 430. No signal line SL may be disposed in the second inactive area NA2. According to another embodiment, the signal lines SL may be disposed in at least any one of the first and second inactive areas NA1 and NA2. For example, at least any one of the plurality of signal lines SL may return to the first inactive area NA1 after detouring the second inactive area NA2.

According to various embodiments, at least one waterproof member may be disposed in at least any one of the display panel 401 having the bending area BA and the housing (e.g., the housing 310 of FIGS. 3A and 3B).

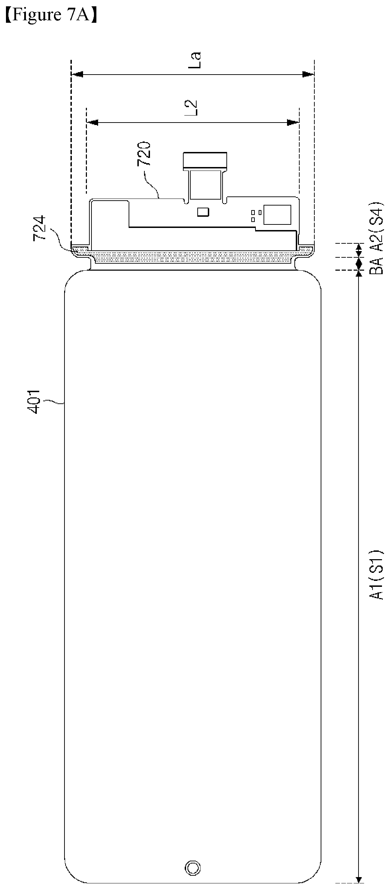

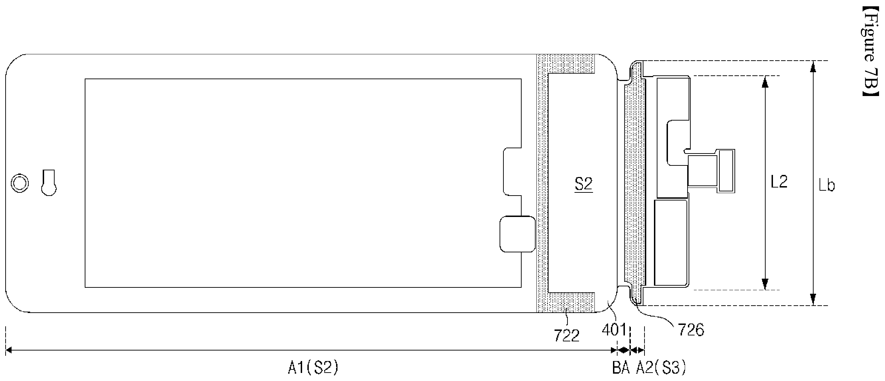

FIGS. 7A and 7B are views illustrating a plurality of waterproof members attached to a front surface and a rear surface of the display panel according to various embodiments.

Referring to FIGS. 7A and 7B, the plurality of waterproof members attached to the display panel 401 may include first to third waterproof members 722, 724, and 726.

The first waterproof member 722 may be disposed on the second surface S2 of the first area A1 of the display panel 401. The first waterproof member 722 is formed to have a "U" shape to surround at least a portion of an area, in which a flexible printed circuit board 720 is to be disposed.

The second waterproof member 724 may be disposed on the fourth surface S4 of the second area A2 of the display panel 401. The second waterproof member 724 may be formed to protrude further than opposite sides of the flexible printed circuit board 720 such that a length La of the second waterproof member 724 is larger than the length L2 of the flexible printed circuit board 720.

The third waterproof member 726 may be disposed on the third surface S3 of the second area A2 of the display panel 401. The third waterproof member 726 may be disposed to overlap at least a portion of the second waterproof member 724 while the second area A2 of the display panel 401 being interposed therebetween. The third waterproof member 726 may be formed to protrude further than opposite sides of the flexible printed circuit board 720 such that a length Lb of the third waterproof member 726 is larger than the length L2 of the flexible printed circuit board 720.

The first to third waterproof members 722, 724, and 726 may include at least any one of a tape, an adhesive, a waterproof dispenser, silicon, a waterproof rubber, and urethane.

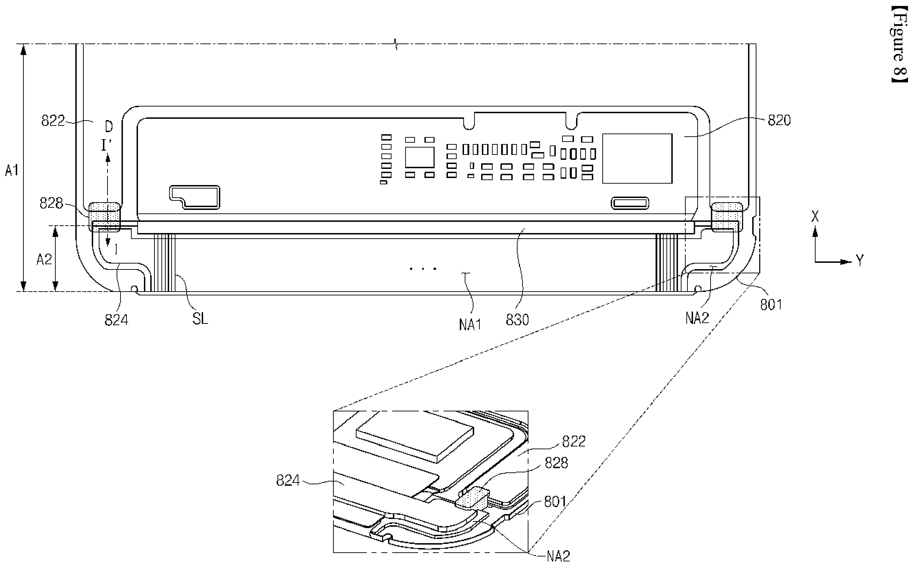

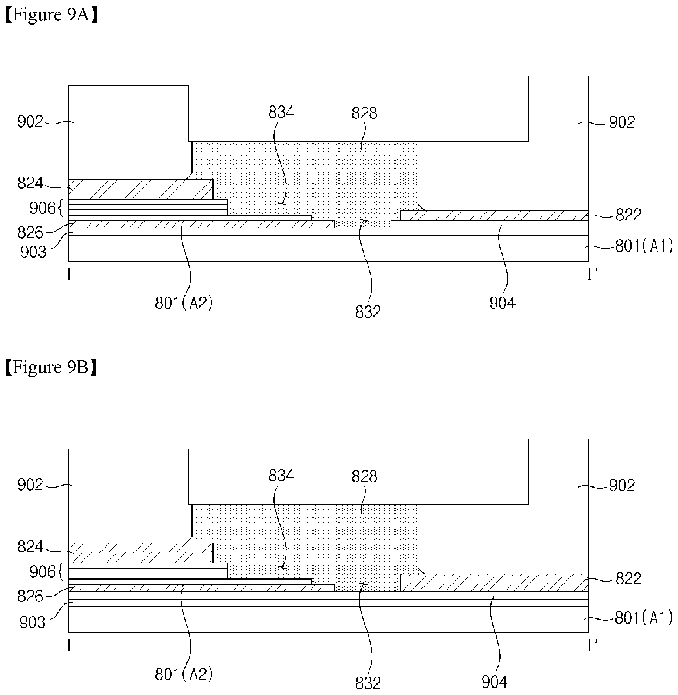

According to various embodiments, the second waterproof member 724 may overlap the bending area BA and the second area A2 of the display, and the first waterproof member 722 may not overlap the bending area BA and the second area A2. A stepped area corresponding to thicknesses of the bending area BA and the second area A2 of the display may be formed between the first and second waterproof members 722 and 724. To seal the stepped area between the first and second waterproof members, the bonding waterproof member may be further disposed. FIG. 8 is a view illustrating the display including the bonding waterproof member according to an embodiment. FIGS. 9A and 9B are cross-sectional views illustrating the electronic device including the display, taken along line I-I' of FIG. 8, according to another embodiment.

Referring to FIGS. 8 to 9B, an electronic device 800 according to an embodiment may include first to third waterproof members 822, 824, and 826, and a bonding waterproof member 828.

The first waterproof member 822 may be disposed between the first area A1 of a display panel 801 and a housing 902. The first waterproof member 822 may be formed to surround the remaining three side surfaces, except for at least one side surface of a flexible printed circuit board 820. As an example, the first waterproof member 822 may be formed to surround the remaining three side surfaces of the flexible printed circuit board 820, except for the side surface of the flexible printed circuit board 820 corresponding to a conductive film 830. For example, the conductive film 830 may be an anisotropic conductive film (ACF).

The second waterproof member 824 may be disposed between the second area A2 of the display panel 801 and the housing 902. The second waterproof member 824 may be disposed to face the first waterproof member 822 in a direction that is parallel to the first direction (direction "X"). For example, the second waterproof member 824 may be disposed to face the first waterproof member 822 in a direction that crosses the signal line SL.

The third waterproof member 826 may be disposed between the first and second areas A1 and A2 of the display panel 801. According to an embodiment, steps may be formed between the second and third waterproof members 824 and 826, and the first waterproof member 822. For example, the third waterproof member 826 may be attached to a rear surface of the first area A1 of the display panel 801, and the first waterproof member 822 may be attached to a first functional member 904 that is located on a rear surface of the first area A1 of the display panel 801. Accordingly, a step corresponding to a thickness of the first functional member 904 may be formed between the first and third waterproof members 822 and 826. Furthermore, the third waterproof member 826, the second area A2 of the display panel 801, and a second functional member 906 may be sequentially stacked between the second waterproof member 824 and the first area A1 of the display panel 801. The first functional member 904 may be disposed between the first waterproof member 822 and the first area A1 of the display panel 801. The second waterproof member 824 may be attached onto the second functional member 906, and the first waterproof member 822 may be attached onto the first functional member 904. Accordingly, a step, a height of which is larger than a thickness of the second area A2 of the display panel 801 may be formed between the first and second waterproof members 822 and 824. Furthermore, the second waterproof member 824 may be disposed on the third waterproof member 826. Accordingly, a step corresponding to an entire thickness of a plurality of thin film layers disposed between the second and third waterproof members 824 and 826 may be formed between the second and third waterproof members 824 and 826. For example, the second area A2 of the display panel 801, the second functional member 906, and the second waterproof member 824 may be sequentially stacked on the third waterproof member 826. Accordingly, a step corresponding to a sum of a thickness of the second area A2 of the display panel 801 and a thickness of the second functional member 906 may be formed between the second and third waterproof members 824 and 826. A plurality of spacing spaces 832 and 834 may be formed between the second and third waterproof members 824 and 826 having the step, and the first waterproof member 822. Moisture and external foreign substances may be introduced into the housing 902 through the spacing spaces 832 and 834. Accordingly, in the disclosure, because the bonding waterproof member 828 is filled in the spacing spaces 832 and 834, stable dust prevention and waterproof performances may be secured.

According to an embodiment, to minimize generation of steps due to the thickness of the second area A2 of the display panel 801, the first functional member 904 may be disposed on a lower side of the first waterproof member 822 not to overlap the second area A2 of the display panel 801. In this relation, the bonding waterproof member 828 may be disposed between the first and third waterproof members 822 and 826. The bonding waterproof member 828, as illustrated in FIG. 9A, may contract a metal plate 903 that is exposed between the first and third waterproof members 822 and 826. The metal plate 903 may be disposed on the entire rear surface of the display 801. For example, the metal plate 903 may be formed of stainless steel (STS) having a lattice shape.

According to various embodiments, the first functional member 904 may be disposed between the first and third waterproof members 822 and 826, and the display panel 801 to reinforce strength, improve heat emission, and for flatness of the display panel 801. The first functional member 904, as illustrated in FIG. 9B, may be disposed on a front surface of the metal plate 903 to cover the metal plate 903. That is, the first and third waterproof members 822 and 826 may be disposed on the first functional member 904. The bonding waterproof member 828 may be disposed to contact the first functional member 904 that is exposed between the first and third waterproof members 822 and 826.

The bonding waterproof member 828 may be disposed between the first and second waterproof members 822 and 824, between the second and third waterproof members 824 and 826, and between the first and third waterproof members 822 and 826. Because the bonding waterproof member 828 connects the first to third waterproof members 822, 824, and 826, the bonding waterproof member 828 and the first to third waterproof members 822, 824, and 826 may define a closed loop that is formed along a periphery of the flexible circuit board 820. Accordingly, because a waterproof and dust prevention path of the electronic device may be provided with no aperture, a stable waterproof and dust prevention function may be provided.

The bonding waterproof member 828 may have a property of being applied in a liquid phase form between the first to third waterproof members 822, 824, and 826, and then being cured by light or heat to be solidified. For example, the bonding waterproof member 828 may be a cured in place gasket (CIPG).

According to an embodiment, the bonding waterproof member 828 may be filled in a space between the adjacent waterproof members 822, 824, and 826 to contact a portion of a side surface of the housing 902. Furthermore, the bonding waterproof member 828 may be disposed to contact the first area A1 of the display panel 901 exposed between the first and third waterproof members 822 and 826.

Furthermore, the bonding waterproof member 828 may be disposed between the first and second waterproof members 822 and 824 that face each other in the first direction (e.g., direction "X"). For example, the bonding waterproof member 828 may be disposed between the first and second waterproof members 822 and 824 that face each other in the first direction (e.g., direction "X") that is parallel to the signal line SL. The bonding waterproof member 828 may be disposed to face at least one side surface of the conductive film 830 and the flexible printed circuit board 820 in the second direction (e.g., direction "Y"). For example, the bonding waterproof member 828 may be disposed at the same location as that of the conductive film 830 formed of an anisotropic conductive film (ACF), or may be disposed at a location that deviates from the conductive film 830.

The bonding waterproof member 828 may overlap the second inactive area NA2 of the display panel 801, in which no signal line SL is disposed. Accordingly, during a rework process, due to removal of the bonding waterproof member 828, the signal line SL may be prevented from being damaged.

In detail, when a self-defect of the bonding waterproof member 828 and a secondary defect due to the bonding waterproof member 828 occur, a rework process may be carried out after the bonding waterproof member 828 is removed. For the rework process, the signal line SL disposed in the first inactive area NA1 may be prevented from being damaged even though the second inactive area NA2, in which the bonding waterproof member 828 is disposed, is deformed by an external force when the bonding waterproof member 828 is removed. Accordingly, in an embodiment, during the rework process, the bonding waterproof member 828 may be easily removed without any damage to the signal line SL.

According to an embodiment, to easily apply the bonding waterproof member 828, a spacing space between the first to third waterproof members 822, 824, and 826 may be formed to have a forward step structure without any reverse step. The components disposed between the housing 902 and the display panel 801 may be disposed to protrude further than an upper component disposed on an upper side thereof.

For example, the first waterproof member 822 may be disposed to protrude further toward the second waterproof member 824 than the housing 902 disposed on an upper side of the first waterproof member 822. The first functional member 904 disposed between the first waterproof member 822 and the first area A1 of the display panel 801 may be disposed to protrude further than the first waterproof member 822.

Accordingly, the first functional member 904, the first waterproof member 822, and the housing 902, which are sequentially stacked on the rear surface (e.g., the second surface S2 of FIG. 6) of the first area A1 of the display panel 801, may be disposed to have a step shape.

The third waterproof member 826 may be disposed to protrude further toward the first waterproof member 822 than the second waterproof member 824 disposed on an upper side of the third waterproof member 826. The second waterproof member 824 may be disposed to protrude further toward the first waterproof member 822 than the housing 902 disposed on an upper side of the second waterproof member 824. Then, the second functional member 906 disposed between the second and third waterproof members 824 and 826 may be disposed to protrude further than the second waterproof member 824, and the second area A2 of the display panel 801 disposed between the second functional member 906 and the third waterproof member 826 may be disposed to protrude further than the second functional member 906.

Accordingly, the third waterproof member 826, the second area A2 of the display panel 801, the second functional member 906, the second waterproof member 824, and the housing 902, which are sequentially stacked on the rear surface (e.g., the second surface S2 of FIG. 6) of the first area A1 of the display panel 801 may be disposed to have a step shape. The second waterproof member 824 may define a forward step on the third waterproof member 826 without any reverse step, between the second and third waterproof members 824 and 826 that form the step shape.

In this case, a width of the first spacing space 832 between the first and third waterproof members 822 and 826 may be smaller than or equal to a width of the second spacing space 834 between the first and second waterproof members 822 and 824. Accordingly, the bonding waterproof member 828 having viscosity may be uniformly injected into the first and second spacing spaces 832 and 834, and thus the first and second spacing spaces 832 and 834 may be easily filled therewith.

Meanwhile, the first and second functional members 904 and 906 may include at least one of an optical sheet, an optical bonding layer, a guide film, a protective plate, a stack type protective layer, and a protective film.

According to an embodiment, the first functional member 904 may include a protective plate. The first functional member 904 may function to prevent an area, except for a closed loop defined by the first to third waterproof members 822, 824, and 826 and the bonding waterproof member 828, from being corroded. The first functional member 904 may be formed of a metal plate. For example, the first functional member 904 may be formed of a copper (Cu) rolled foil plate, or stainless steel (STS).

According to an embodiment, the second functional member 906 may include a stack type protective layer. The second functional member 906 may have a multilayered structure, in which a conductive layer, a nonconductive layer, and an adhesive layer are laminated. For example, the second functional member 906 may be formed by sequentially stacking the nonconductive layer, the conductive layer, and a black nonconductive layer, and disposing the adhesive layer between the adjacent layers. The black nonconductive layer may function to shield radiated noise. The nonconductive layer may function to mask a part (e.g., a DDI) in the electronic device or an area that causes other damages such that static electricity applied to a conductive layer is prevented from flowing to the part or the area before the static electricity is offset by a ground. The conductive layer may be electrically connected to a ground through the flexible printed circuit board 820 and the conductive structure (for example, the housing) of the electronic device. The conductive layer may function to offset the induced static electricity through the flexible printed circuit board 820 and a conductive structure (for example, the housing) of the electronic device. Accordingly, the second functional member 906 may prevent the parts mounted on the flexible printed circuit board 820 from being damaged by the static electricity and protect the parts from radiated noise.

According to various embodiments, the bonding waterproof member 828 may be formed through the injection hole disposed in the housing 902.

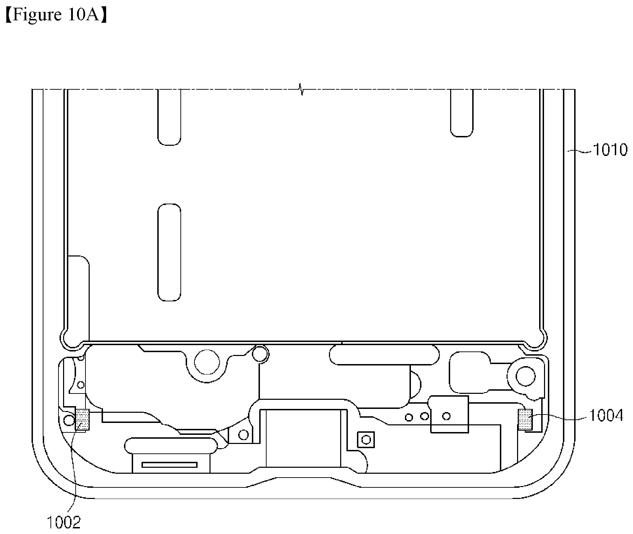

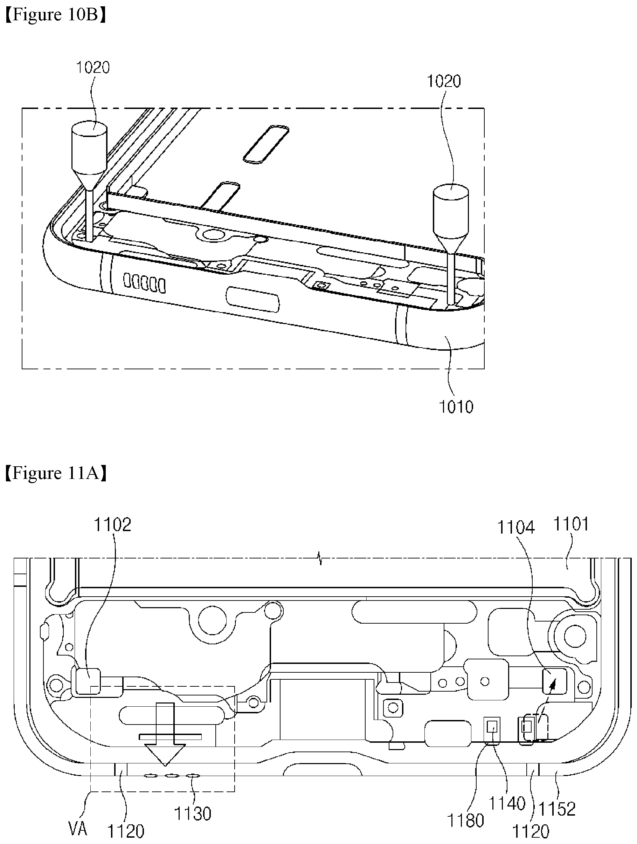

FIGS. 10A and 10B are views illustrating the housing of the electronic device including the injection hole for injecting the bonding waterproof member according to an embodiment.

Referring to FIGS. 10A and 10B, a housing 1010 may include injection holes 1002 and 1004 that pass through the housing 1010. The injection holes 1002 and 1004 may be formed in an area corresponding to a spacing space (e.g., the spacing spaces 832 and 834 of FIGS. 8, 9A, and 9B) filled with the bonding waterproof member (e.g., the bonding waterproof member 828 of FIGS. 8, 9A, and 9B).

Accordingly, in a state in which the display in the housing 1010 and the first to third waterproof members (e.g., the first to third waterproof members 822, 824, and 826 of FIG. 8) are disposed, the bonding waterproof member 828 from a dispenser 1020 may be injected into the spacing spaces 832 and 834 through the injection holes 1002 and 1004 that pass through the housing 1010. The injection holes 1002 and 1004 may be finished by a separate cover when the bonding waterproof member 828 is completely injected.

According to various embodiments, the injection holes 1002 and 1004 of the housing 1010 may be disposed not to be interfered with a non-display module disposed to be adjacent to the side member (e.g., the side members 352, 354, 362, and 364 of FIGS. 3A and 3B) of the housing 1010.

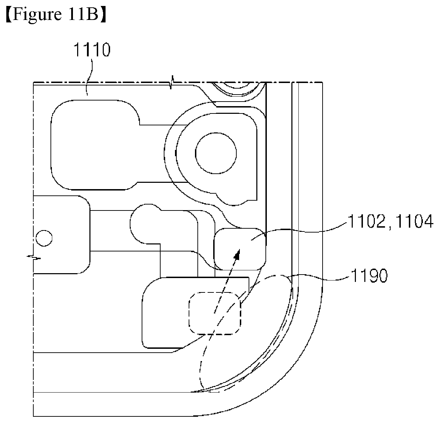

FIGS. 11A and 11B are views illustrating a disposition relationship of the electronic parts disposed in the housing of the electronic device according to an embodiment, and the injection holes.

Referring to FIGS. 11A and 11B, injection holes 1102 and 1104 of a housing 1101 may be disposed to be spaced apart from a third side member 1152 of the housing 1101. The injection holes 1102 and 1104 of the housing 1101 may be disposed at a distance that is spaced further from the third side member 1152 of the housing 1101 than at least one part (e.g., the non-display module) disposed at an upper end and a lower end of the housing 1101. For example, the non-display module may include an antenna contact part 1140, a sound output device including a speaker 1130, a segmentation part 1120 that electrically insulates the housing 1101 and the antenna, and a cover waterproof tape.

A first contact part 1140 for an antenna according to an embodiment, as illustrated in FIG. 11A, may contact a second contact part 1180 of a circuit board for an antenna in a depth direction of the injection hole 1104. When the injection holes 1102 and 1104 are disposed in areas, which the first and second contact parts 1140 and 1180 contact, a contact area of the first and second contact parts 1140 and 1180 may become smaller. Accordingly, because the injection holes 1102 and 1104 according to an embodiment are disposed in an area, except for an area in which the first and second contact parts 1140 and 1180 contact each other, the contact area of the first and second contact parts 1140 and 1180 may be secured. For example, the injection holes 1102 and 1104 may be disposed on an inner side of the housing 1101 than the first and second contact parts 1140 and 1180.

The injection holes 1102 and 1104 according to an embodiment, as illustrated in FIG. 11A, are disposed to be spaced apart from the third side member 1152 of the housing 1101, a spacing distance between the injection holes 1102 and 1104 and the segmentation part 1120 may become larger. Accordingly, in an embodiment, a strength of the segmentation part 1120 due to the injection holes 1102 and 1104 may be prevented from being degraded, and a strength of the segmentation part 1120 may be reinforced.

At least a portion of the injection holes 1102 and 1104 according to an embodiment, as illustrated in FIG. 11A, may overlap at least a portion of the sound output device including the speaker 1130. For example, the injection holes 1102 and 1104 ma not overlap a pipeline, in which a sound signal travels, and the injection holes 1102 and 1104 may be disposed to overlap at least a portion of a volume space VA of the sound output device, except for the pipeline, in which the sound signal travels. The injection holes 1102 and 1104 may be disposed not to overlap the pipeline, in which the sound signal travels, and the volume space VA of the sound output device. Accordingly, in various embodiments, the volume space of the sound output device 1130 including the speaker 1130 and the pipeline may be secured.

The injection holes 1102 and 1104 according to an embodiment, as illustrated in FIGS. 11B, may be formed not to overlap a cover waterproof tape forming area 1190 that is disposed between a back cover (e.g., the rear plate 111 of FIG. 1) and the housing 1101. Accordingly, because an area of the cover waterproof tape located on the rear surface of the housing 1101 may be secured, a waterproof stability may be prevented from being degraded when an impact is applied to a corner portion of the electronic device. Meanwhile, FIG. 11B illustrates that the cover waterproof tape forming area 1190 corresponds to the corner portion of the electronic device, but the disclosure is not limited thereto. The cover waterproof tape may extend along a side surface connected to the corner portion, as well as the corner portion.

In this way, in an embodiment, because it is not necessary to adjust a size of the non-display modules, which are disposed at an upper end and a lower end of the housing 1101 to dispose the injection holes 1102 and 1104, a high degree of freedom of design may be provided.

According to various embodiments, the electronic device 100 may be a foldable electronic device, of which an active area (e.g., the active area AA of FIG. 6) of the display 101 may be folded.

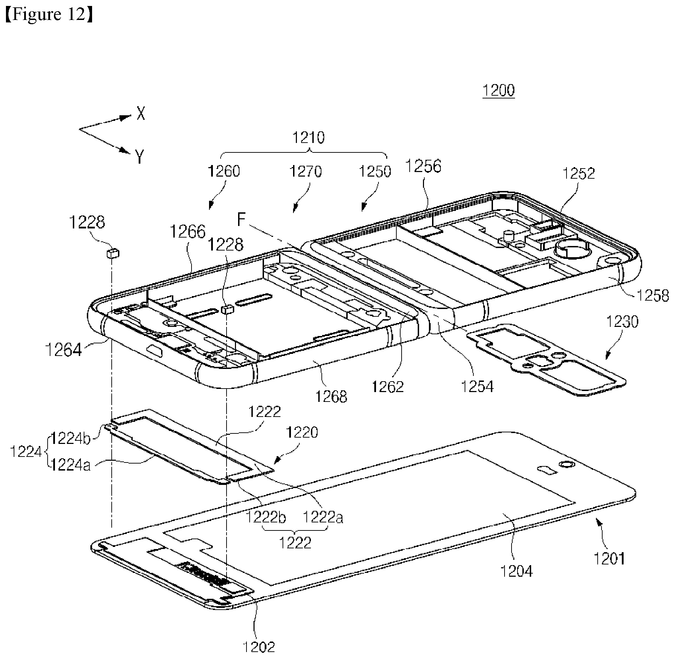

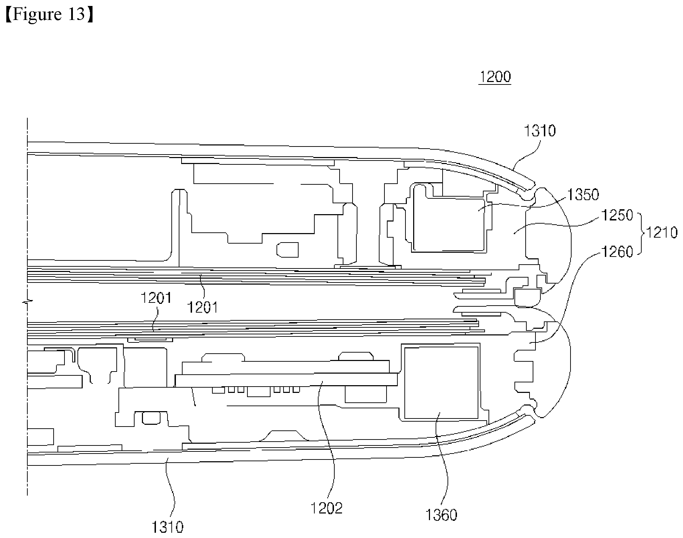

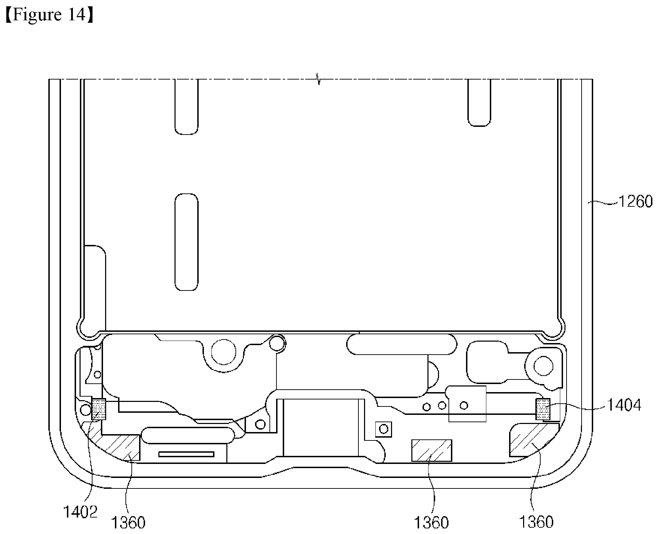

FIG. 12 is a rear perspective view illustrating the unfolded state of the foldable electronic device according to various embodiments. FIG. 13 is a cross-sectional view illustrating the folded state of the electronic device according to various embodiments. FIG. 14 is a view illustrating a disposition relationship of a magnetic body and the bonding waterproof member illustrated in FIG. 13.

Referring to FIGS. 12 to 14, a foldable electronic device 1200 of an embodiment may include a foldable housing 1210, waterproof members 1220 and 1230, and a foldable display 1201.

The foldable housing 1210 may include first and second housings 1260 and 1250 that are disposed while a hinge part 1270 being interposed therebetween. Each of the first and second housings 1260 and 1250 may include a plurality of side members that surround a side surface of the display 101.

The first housing 1260 may include first to fourth side members 1262, 1264, 1266, and 1268. The first and second side members 1262 and 1264 may be disposed to extend in the second direction "Y" and face each other in the first direction "X" that is different from the second direction "Y". In various embodiments, the first direction "X" may cross the second direction "Y".

The third and fourth side members 1266 and 1268 may be disposed to extend in the first direction "X" and face each other in the second direction "Y" that is different from the first direction. The third and fourth side members 1266 and 1268 may be disposed between the first and second side members 1262 and 1264. For example, lengths of the third and fourth side members 1266 and 1268 may be larger or smaller than lengths of the first and second side members 1262 and 1264.

The second housing 1250 may include fifth to eighth side members 1252, 1254, 1256, and 1258. When the electronic device 1200 is in a folded state, the fifth side member 1252 may face the first side member 1262, the sixth side member 1254 may face the second side member 1264, the seventh side member 1256 may face the third side member 1266, and the eighth side member 1258 may face the fourth side member 1268.

The fifth and sixth side members 1252 and 1254 may be disposed to extend in the second direction "Y" and face each other in the first direction "X" that is different from the second direction "Y". For example, the fifth and sixth side members 1252 and 1254 may be disposed to be parallel to the first and second side members 1262 and 1264. In various embodiments, the first direction "X" may cross the second direction "Y".

The seventh and eighth side members 1256 and 1258 may be disposed to extend in the first direction "X" and face each other in the second direction "Y" that is different from the first direction. The seventh and eighth side members 1256 and 1258 may be disposed to be parallel to the third and fourth side members 1266 and 1268. The seventh and eighth side members 1256 and 1258 may be disposed between the fifth and sixth side members 1252 and 1254. Lengths of the seventh and eighth side members 1256 and 1258 may be larger or smaller than lengths of the fifth and sixth side members 1252 and 1254.

The first and second housings 1260 and 1250 may be coupled to be rotatable about a folding axis "F" through the hinge part 1270. Magnetic bodies 1360 and 1350 may be accommodated in the first and second housings 1260 and 1250. The first magnetic body 1360 accommodated in the first housing 1260 and the second magnetic body 1350 accommodated in the second housing 1250 may be disposed on the same vertical line to overlap each other when the electronic device 1200 is in the folded state. Accordingly, a magnetic force (e.g., an attractive force) between the first and second magnetic bodies 1360 and 1350 may be prevented from being degraded, the electronic device 1200 may be maintained in the folded state stably.

According to an embodiment, the electronic device 1200 may be folded in an in-folding scheme of folding the display 1201 inwards, and in an out-folding scheme of folding the display 1201 outwards.

The flexible printed circuit board 1202, the battery 1204, and the like may be accommodated in an interior space of the housing 1210, and because the display 1201 is mounted on a front surface of the housing 1210, the housing 1210 may finish an external appearance of the electronic device 1200.

The display 1201 may display an image by using a plurality of pixels. The display 1201 may be bonded to a front surface of the housing 1210 by using the waterproof members 1220 and 1230 having viscosity.

The waterproof members 1220 and 1230 may be disposed between the housing 1210 and the display 1201. The waterproof members 1230 and 1220 may include the upper end waterproof member 1230 and the lower end waterproof member 1220.

The upper end waterproof member 1230 may be formed at an upper end of the first housing 1260 to couple a portion of the display 1201 to an upper end of the first housing 1256. Then, a front cam hole, a sensor hole, or a receiver part (for example, the receiver and the speaker for voice communication of FIG. 2) may be disposed at an upper end of the first housing 1260.

The lower end waterproof member 1220 may be coupled a portion of the display 1201 to a lower end of the second housing 1250. Then, the printed circuit board 1202, on which a processor, a memory, and/or an interface are mounted, may be disposed at a lower end of the second housing 1250.

The lower end waterproof member 1220 may include first and second waterproof members 1222 and 1224, and a bonding waterproof member 1228. Here, the first and second waterproof members 1222 and 1224 and the bonding waterproof member 1228 may be at least partially similar to the waterproof members 322, 324, and 328 of FIGS. 3A and 3B, or may further include another embodiment of the waterproof members 322, 324, and 328 of FIGS. 3A and 3B.

The first waterproof member 1222 may be disposed between the flexible printed circuit board 302 and the battery 370. The first waterproof member 1222 may include first and second waterproof sealing areas 1222a and 1222b.

The first waterproof sealing area 1222a may be disposed between the flexible printed circuit board 1202 and the battery 1270. The first waterproof sealing area 1222a may be disposed in parallel to the first and second side members 1262 and 1264 of the first housing 1260.

The second waterproof sealing area 1222b may extend from opposite sides of the first waterproof sealing area 1222a toward the second side member 1264 of the housing 1210. The second waterproof sealing area 1222b may be disposed to face a side surface of the flexible printed circuit board 1202. A length of the second waterproof sealing area 1222b may be smaller than a length of the first waterproof sealing area 1222a.

The second waterproof member 1224 may be disposed to be closer to the second side member 1264 of the housing 1210 than to the first waterproof member 1222. The second waterproof member 1224 may include third and fourth waterproof sealing areas 1224a and 1224b.

The third waterproof sealing area 1224a may be disposed between the flexible printed circuit board 1202 and the second side member 1264 of the housing 1210. The third waterproof sealing area 1224a may be disposed to face the first waterproof sealing area 1224a in the first direction "X" that is parallel to the third and fourth side members 1266 and 1268 of the housing 1210.

The fourth waterproof sealing area 1224b may extend from opposite sides of the third waterproof sealing area 1224a toward the second waterproof sealing area 1222b. The fourth waterproof sealing area 1224b may be disposed to second the second waterproof sealing area 1222b in the first direction "X" that is parallel to the third and fourth side members 1266 and 1268 of the housing 1210. A length of the fourth waterproof sealing area 1224b may be smaller than a length of the third waterproof sealing area 1224a and a length of the second waterproof sealing area 1222b. A corner portion of the fourth waterproof sealing area 1224b may be formed to face corner portions, at which the third and fourth side members 1262 and 1264 and the second side member 1254 meet each other.

In an embodiment, the second waterproof member 1224 may include only the third waterproof sealing area 1224a without any fourth waterproof sealing area 1224b. In this case, the third waterproof sealing area 1224a may be disposed to face the second waterproof sealing area 1222b. A corner portion of the third waterproof sealing area 1224a may be formed to face corner portions, at which the third and fourth side members 1266 and 1268 and the second side member 1264 meet each other.

The first and second waterproof members 1222 and 1224 may be disposed to face each other in the first direction "X" that is parallel to the third and fourth side members 2266 and 1268 of the housing 1210 while the bonding waterproof member 1228 being interposed therebetween. Because the bonding waterproof member 1228 is disposed between the first and second waterproof members 1222 and 1224, the bonding waterproof member 1228, and the first and second waterproof members 1222 and 1224 may be formed in a closed loop form that surrounds the printed circuit board 1202. Accordingly, because a waterproof and dust prevention path of the electronic device 1200 may be provided with no aperture, a stable waterproof and dust prevention function may be provided.

The foldable electronic device 1200 according to an embodiment may display a screen in the unfolded state and the folded state according to a request by the user. For example, a closing force of the foldable electronic device 1200 means a torque in a folding direction. The torque is proportional to an attractive force between the first and second magnetic bodies 1360 and 1350, and a distance from the folding axis "F". Accordingly, the first and second magnetic bodies 1360 and 1350 disposed in the housing 1210 of the electronic device 1200 may be mounted to edges of the first and second housings 1250 and 1260, which are far from the folding axis "F".

When the magnetic bodies 1360 and 1350 accommodated in the first and second housings 1260 and 1250 are disposed to be spaced apart from each other not to overlap the bonding waterproof member 1228 injected through injection holes 1402 and 1404 provided in the second housing 1250, they may be maintained while the sizes of the first and second magnetic bodies 1360 and 1350 are reduced.

In an embodiment, the bonding waterproof member 1228 may be disposed on the same line as at least any one of the conductive film and the flexible printed circuit board 1202. The bonding waterproof member 1228, the conductive film, and the flexible printed circuit board 1202 may be disposed on a line that is parallel to the second direction. Then, the bonding waterproof member 1228 may be disposed to be closer to the third and fourth side members 1266 and 1268 of the first housing 1260 than to at least one of the conductive film and the flexible printed circuit board 1202, which are located on the same line. Accordingly, because the bonding waterproof member 1228 is disposed to be spaced apart from the magnetic bodies 1360 and 1350 while not overlapping them, the sizes of the first and second magnetic bodies 1360 and 1350 may be prevented from becoming smaller due to the injection holes 1402 and 1404. Due to the first and second magnetic bodies 1360 and 1350, the foldable electronic device may maintain a closing force without any degradation of a magnetic force.

The bonding waterproof member according to various embodiments may face a side surface of the conductive film or may face other constituent members adjacent to the conductive film.

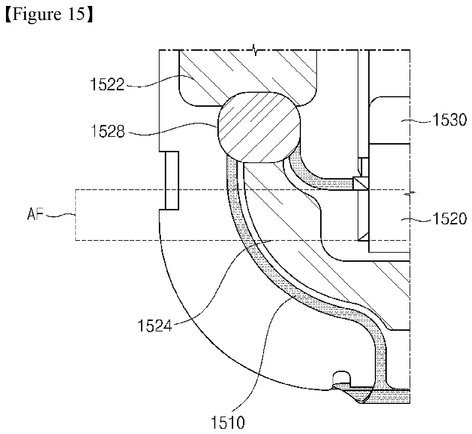

FIG. 15 is a view illustrating a disposition relationship of the flexible printed circuit board and the bonding waterproof member according to various embodiments.

Referring to FIG. 15, a second inactive area 1510 of the display panel may extend toward a first waterproof member 1522 to face a side surface of a conductive film 1520. For example, the conductive film 1520 may be an anisotropic conductive film (ACF). In addition, the second inactive area 1510 of the display panel may extend toward the first waterproof member 1522 to face a side surface of the conductive film 1520 and a side surface of a flexible circuit board 1530. The second inactive area 1510 may pass through an imaginary area AF located on the same line as the conductive film 1520 and extend toward the first waterproof member 1522. A second waterproof member 1524 may be disposed on the extended second inactive area 1510 of the display panel. Accordingly, a bonding waterproof member 1528 may be disposed in an area, except for the imaginary area AF that does not overlap the side surface of the conductive film 1520. For example, the bonding waterproof member 1528 disposed between the first and second waterproof members 1522 and 1524 may be disposed at a location that deviates from the conductive film 1520 formed of the anisotropic conductive film (ACF). The bonding waterproof member 1528 may be disposed between the conductive film 1520 and the flexible circuit board 1530 instead of in an area between the bending area BA and the conductive film 1520, or may be disposed to face the flexible circuit board 1530. For example, the bonding waterproof member 1528 may face a side surface of the flexible circuit board 1530 or may face a side surface of the conductive film 1520 and a side surface of the flexible circuit board 1530.

According to various embodiments, an electronic device may include a housing including a first side member and a second side member facing each other in a first direction, and a third side member and a fourth side member facing each other in a second direction that is different from the first direction, a display panel disposed in the housing, a conductive film connected to the display panel, a circuit board connected to the conductive film, a first waterproof member spaced apart from the circuit board, a second waterproof member facing the first waterproof member in the first direction, and disposed to be closer to the third side member and the fourth side member than to the conductive film, and a bonding waterproof member disposed between the first waterproof member and the second waterproof member, and facing a side surface of at least any one of the conductive film and the circuit board in the second direction.

According to various embodiments, the housing may include an injection hole disposed in an area corresponding to the bonding waterproof member.

According to various embodiments, the electronic device may further include a non-display module received in the housing, and the injection hole may not overlap the non-display module.

According to various embodiments, the non-display module may include at least any one of an antenna, a cover waterproof tape, and a segmentation part.

According to various embodiments, the electronic device may further include a first magnetic body received in the housing, and a second magnetic body received in the housing to face the first magnetic body, and the injection hole may not overlap at least any one of the first magnetic body and the second magnetic body.

According to various embodiments, the display panel may include a first area, a second area, and a bending area located between the first area and the second area, the second area may include a first inactive area extending from the bending area, and second inactive areas extending from opposite sides of the first inactive area, and a width of the second area may be larger than a width of the bending area.

According to various embodiments, the second waterproof member is disposed on surfaces of the first inactive area and the second inactive areas.

According to various embodiments, the electronic device may further include a third waterproof member disposed on opposite surfaces of the first inactive area and the second inactive areas.

According to various embodiments, the first waterproof member may be disposed between the first area and the housing, the second waterproof member may be disposed between the second area and the housing, and the third waterproof member may be disposed between the first area and the second area.

According to various embodiments, a plurality of signal lines may be disposed in at least any one of the first inactive area and the second inactive area.

According to various embodiments, the second inactive areas may be disposed to be closer to the second side member and the third side member than to the conductive film.

According to various embodiments, the second waterproof member may overlap the second inactive areas.

According to various embodiments, the first waterproof member may be disposed to surround at least three surfaces of the circuit board, and the second waterproof member may be disposed to surround at least one surface of the conductive film.

According to various embodiments, the first waterproof member may include a first waterproof sealing member being parallel to the first side member and the second side member, and a second waterproof sealing member extending from the first waterproof sealing member toward the third side member, and the second waterproof member may include a third waterproof sealing member being parallel to the first waterproof sealing member, and a fourth waterproof sealing member extending from the third waterproof sealing member toward the second waterproof sealing member.

According to various embodiments, a corner portion of the fourth waterproof sealing member may face a corner portion, at which the third side member and the fourth side member meet the second side member.

According to various embodiments, an electronic device may include a housing including a first side member and a second side member facing each other in a first direction, and a third side member and a fourth side member facing each other in a second direction that is different from the first direction, a display panel disposed in the housing, a conductive film connected to the display panel, a circuit board connected to the conductive film, a first waterproof member surrounding at least three surfaces of the circuit board and spaced apart from the circuit board, a second waterproof member surrounding at least one surface of the conductive film, facing the first waterproof member in the first direction, and disposed to be closer to the third side member and the fourth side member than to the conductive film, and a bonding waterproof member disposed between the first waterproof member and the second waterproof member, and facing a side surface of at least any one of the conductive film and the circuit board.

According to various embodiments, the housing may include an injection hole disposed in an area corresponding to the bonding waterproof member.

According to various embodiments, the electronic device may further include a non-display module received in the housing, the injection hole may not overlap the non-display module, and the non-display module may include at least any one of an antenna, a cover waterproof tape, a segmentation part, and a magnetic body.

According to various embodiments, the display panel may include a first area, a second area, and a bending area located between the first area and the second area, the second area may include a first inactive area extending from the bending area, and second inactive areas extending from opposite sides of the first inactive area, and a width of the second area may be larger than a width of the bending area.

According to various embodiments, the second inactive areas may be disposed to be closer to the second side member and the third side member than to the conductive film, and the second waterproof member may overlap the second inactive areas.

According to various embodiments, the conductive film may be an anisotropic conductive film (ACF).

Various embodiments of the disclosure and terms used herein are not intended to limit the technologies described in the disclosure to specific embodiments, and it should be understood that the embodiments and the terms include modifications on the corresponding embodiments described herein. With regard to description of drawings, similar components may be marked by similar reference numerals. The terms of a singular form may include plural forms unless otherwise specified. In the disclosure disclosed herein, the expressions "A or B", "at least one of A and/or B", "A, B, or C", or "at least one of A, B, and/or C", and the like used herein may include any and all combinations of one or more of the associated listed items. Expressions such as "first," or "second," and the like, may express their components regardless of their priority or importance and may be used to distinguish one component from another component but is not limited to these components. When an (e.g., first) component is referred to as being "(operatively or communicatively) coupled with/to" or "connected to" another (e.g., second) component, it may be directly coupled with/to or connected to the other component or an intervening component (e.g., a third component) may be present.

According to the situation, the expression "adapted to or configured to" used herein may be interchangeably used as, for example, the expression "suitable for", "having the capacity to", "changed to", "made to", "capable of" or "designed to" in hardware or software. The expression "a device configured to" may mean that the device is "capable of" operating together with another device or other parts. For example, a "processor configured to (or set to) perform A, B, and C" may mean a dedicated processor (e.g., an embedded processor) for performing corresponding operations or a generic-purpose processor (e.g., a central processing unit (CPU) or an application processor (AP)) which performs corresponding operations by executing one or more software programs which are stored in a memory device (e.g., the memory AAA30).

The term "module" used herein may include a unit, which is implemented with hardware, software, or firmware, and may be interchangeably used with the terms "logic", "logical block", "part", "circuit", or the like. The "module" may be a minimum unit of an integrated part or a part thereof or may be a minimum unit for performing one or more functions or a part thereof. The "module" may be implemented mechanically or electronically and may include, for example, an application-specific IC (ASIC) chip, a field-programmable gate array (FPGA), and a programmable-logic device for performing some operations, which are known or will be developed.

At least a part of an apparatus (e.g., modules or functions thereof) or a method (e.g., operations) according to various embodiments may be, for example, implemented by instructions stored in a computer-readable storage media (e.g., the memory) in the form of a program module. The instruction, when executed by a processor (e.g., the processor), may cause the processor to perform a function corresponding to the instruction. The computer-readable recording medium may include a hard disk, a floppy disk, a magnetic media (e.g., a magnetic tape), an optical media (e.g., a compact disc read only memory (CD-ROM) and a digital versatile disc (DVD), a magnetooptical media (e.g., a floptical disk)), an embedded memory, and the like. The one or more instructions may contain a code made by a compiler or a code executable by an interpreter.

Each component (e.g., a module or a program module) according to various embodiments may be composed of single entity or a plurality of entities, a part of the above-described sub-components may be omitted, or other sub-components may be further included. Alternatively or additionally, after being integrated in one entity, some components (e.g., a module or a program module) may identically or similarly perform the function executed by each corresponding component before integration. According to various embodiments, operations executed by modules, program modules, or other components may be executed by a successive method, a parallel method, a repeated method, or a heuristic method, or at least one part of operations may be executed in different sequences or omitted. Alternatively, other operations may be added.

## Claims

1. An electronic device (100; 1200) comprising:
a housing (110; 1260) including a first side member (1262) and a second side member (1264) facing each other in a first direction, and a third side member (1266) and a fourth side member (1268) facing each other in a second direction that is different from the first direction;
a display panel (401; 801; 1201) disposed in the housing (110; 1260);
a conductive film (430; 830) connected to the display panel (401; 801; 1201);
a circuit board (420; 1202) connected to the conductive film (430; 830);
a first waterproof member (822; 1222) spaced apart from the circuit board (420; 1202);
a second waterproof member (824; 1224) facing the first waterproof member (822; 1222) in the first direction, and disposed to be closer to the third side member (1266) and the fourth side member (1268) than to the conductive film (430; 830); and
a bonding waterproof member (828; 1228) disposed between the first waterproof member (822; 1222) and the second waterproof member (824; 1224), and facing a side surface of at least any one of the conductive film (430; 830) and the circuit board (420; 1202) in the second direction.

2. The electronic device (100; 1200) of claim 1, wherein the housing (110; 1260) includes an injection hole disposed in an area corresponding to the bonding waterproof member (828; 1228).

3. The electronic device (100; 1200) of claim 2, further comprising:
a non-display module accommodated in the housing (110; 1260),
wherein the injection hole does not overlap the non-display module.

4. The electronic device (100; 1200) of claim 3, wherein the non-display module includes at least any one of an antenna, a cover waterproof tape, and a segmentation part.

5. The electronic device (100; 1200) of any one of claims 2 to 4, further comprising:
a first magnetic body (1360) accommodated in the housing (110; 1260); and
a second magnetic body (1350) accommodated in the housing (110; 1260) to face the first magnetic body (1360),
wherein the injection hole does not overlap at least any one of the first magnetic body (1360) and the second magnetic body (1350).

6. The electronic device (100; 1200) of any one of claims 1 to 5, wherein the display panel (401; 801; 1201) includes a first area (A1), a second area (A2), and a bending area (BA) located between the first area (A1) and the second area (A2),
wherein the second area (A2) includes:
a first inactive area (NA1) extending from the bending area (BA); and
second inactive areas (NA2) extending from opposite sides of the first inactive area (NA1), and
wherein a width of the second area (A2) is larger than a width of the bending area (BA).

7. The electronic device (100; 1200) of claim 6, wherein the second waterproof member (824; 1224) is disposed on surfaces of the first inactive area (NA1) and the second inactive areas (NA2).

8. The electronic device (100; 1200) of claim 6 or claim 7, further comprising:
a third waterproof member (826) disposed on opposite surfaces of the first inactive area (NA1) and the second inactive areas (NA2), and
wherein the first waterproof member (822; 1222) is disposed between the first area (A1) and the housing (110; 1260),
wherein the second waterproof member (824; 1224) is disposed between the second area (A2) and the housing (110; 1260), and
wherein the third waterproof member (826) is disposed between the first area (A1) and the second area (A2).

9. The electronic device (100; 1200) of any one of claims 6 to 8, wherein a plurality of signal lines (SL) are disposed in at least any one of the first inactive area (NA1) and the second inactive areas (NA2).

10. The electronic device (100; 1200) of any one of claims 6 to 9, wherein the second inactive areas (NA2) are disposed to be closer to the second side member (1264) and the third side member (1266) than to the conductive film (430; 830).

11. The electronic device (100; 1200) of any one of claims 6 to 10, wherein the second waterproof member (824; 1224) overlaps the second inactive areas (NA2).

12. The electronic device (100; 1200) of any one of claims 1 to 11, wherein the first waterproof member (822; 1222) is disposed to surround at least three surfaces of the circuit board (420; 1202), and
wherein the second waterproof member (824; 1224) is disposed to surround at least one surface of the conductive film (430; 830).

13. The electronic device (100; 1200) of any one of claims 1 to 12, wherein the first waterproof member (822; 1222) includes:
a first waterproof sealing member being parallel to the first side member (1262) and the second side member (1264); and
a second waterproof sealing member extending from the first waterproof sealing member toward the third side member (1266),
wherein the second waterproof member (824; 1224) includes:
a third waterproof sealing member being parallel to the first waterproof sealing member; and
a fourth waterproof sealing member extending from the third waterproof sealing member toward the second waterproof sealing member.

14. The electronic device (100; 1200) of claim 13, wherein a corner portion of the fourth waterproof sealing member faces a corner portion at which the third side member (1266) and the fourth side member (1268) meet the second side member (1264).

15. The electronic device (100; 1200) of any one of claims 1 to 14, wherein the conductive film (430; 830) is an anisotropic conductive film, ACF.

## Patentansprüche

1. Elektronische Vorrichtung (100; 1200), umfassend:
ein Gehäuse (110; 1260), das ein erstes Seitenelement (1262) und ein zweites Seitenelement (1264) umfasst, die einander in einer ersten Richtung zugewandt sind, und ein drittes Seitenelement (1266) und ein viertes Seitenelement (1268), die einander in einer zweiten Richtung zugewandt sind, die sich von der ersten Richtung unterscheidet;
eine Anzeigetafel (401; 801; 1201), die im Gehäuse (110; 1260) angeordnet ist,
eine leitende Folie (430; 830), die mit der Anzeigetafel (401; 801; 1201) verbunden ist,
eine Leiterplatte (420; 1202), die mit der leitenden Folie (430; 830) verbunden ist;
ein erstes wasserdichtes Element (822; 1222), das von der Leiterplatte (420; 1202) beabstandet ist;
ein zweites wasserdichtes Element (824; 1224), das dem ersten wasserdichten Element (822; 1222) in der ersten Richtung zugewandt und so angeordnet ist, dass es dem dritten Seitenelement (1266) und dem vierten Seitenelement (1268) näher ist als der leitenden Folie (430; 830); und
ein wasserdichtes Verbindungselement (828; 1228), das zwischen dem ersten wasserdichten Element (822; 1222) und dem zweiten wasserdichten Element (824; 1224) angeordnet ist und in der zweiten Richtung einer seitlichen Fläche von mindestens einem von der leitenden Folie (430; 830) und der Leiterplatte (420; 1202) zugewandt ist.

2. Elektronische Vorrichtung (100; 1200) nach Anspruch 1, wobei das Gehäuse (110; 1260) ein Einspritzloch umfasst, das in einem Bereich angeordnet ist, der dem wasserdichten Verbindungselement (828; 1228) entspricht.

3. Elektronische Vorrichtung (100; 1200) nach Anspruch 2, ferner umfassend:
ein Nicht-Anzeigemodul, das im Gehäuse (110; 1260) untergebracht ist,
wobei das Einspritzloch das Nicht-Anzeigemodul nicht überlappt.

4. Elektronische Vorrichtung (100; 1200) nach Anspruch 3, wobei das Nicht-Anzeigemodul mindestens eines von einer Antenne, einem wasserdichten Abdeckband und ein Segmentierungsteil umfasst.

5. Elektronische Vorrichtung (100; 1200) nach einem der Ansprüche 2 bis 4, ferner umfassend:
einen ersten magnetischen Körper (1360), der im Gehäuse (110; 1260) untergebracht ist; und
einen zweiten magnetischen Körper (1350), der im Gehäuse (110; 1260) untergebracht ist und dem ersten magnetischen Körper (1360) zugewandt ist,
wobei das Einspritzloch mindestens einen von dem ersten magnetischen Körper (1360) und dem zweiten magnetischen Körper (1350) nicht überlappt.

6. Elektronische Vorrichtung (100; 1200) nach einem der Ansprüche 1 bis 5, wobei die Anzeigetafel (401; 801; 1201) einen ersten Bereich (A1), einen zweiten Bereich (A2) und einen Biegebereich (BA) umfasst, der zwischen dem ersten Bereich (A1) und dem zweiten Bereich (A2) liegt,
wobei der zweite Bereich (A2) Folgendes umfasst:
einen ersten inaktiven Bereich (NA1), der sich von dem Biegebereich (BA) aus erstreckt; und
zweite inaktive Bereiche (NA2), die sich von gegenüberliegenden Seiten des ersten inaktiven Bereichs (NA1) erstrecken, und
wobei eine Breite des zweiten Bereichs (A2) größer ist als eine Breite des Biegebereichs (BA).

7. Elektronische Vorrichtung (100; 1200) nach Anspruch 6, wobei das zweite wasserdichte Element (824; 1224) auf Flächen des ersten inaktiven Bereichs (NA1) und der zweiten inaktiven Bereiche (NA2) angeordnet ist.

8. Elektronische Vorrichtung (100; 1200) nach Anspruch 6 oder Anspruch 7, ferner umfassend:
ein drittes wasserdichtes Element (826), das auf gegenüberliegenden Flächen des ersten inaktiven Bereichs (NA1) und des zweiten inaktiven Bereichs (NA2) angeordnet ist, und
wobei das erste wasserdichte Element (822; 1222) zwischen dem ersten Bereich (A1) und dem Gehäuse (110; 1260) angeordnet ist,
wobei das zweite wasserdichte Element (824; 1224) zwischen dem zweiten Bereich (A2) und dem Gehäuse (110; 1260) angeordnet ist, und
wobei das dritte wasserdichte Element (826) zwischen dem ersten Bereich (A1) und dem zweiten Bereich (A2) angeordnet ist.

9. Elektronische Vorrichtung (100; 1200) nach einem der Ansprüche 6 bis 8, wobei eine Vielzahl von Signalleitungen (SL) in mindestens einem des ersten inaktiven Bereichs (NA1) und der zweiten inaktiven Bereiche (NA2) angeordnet sind.

10. Elektronische Vorrichtung (100; 1200) nach einem der Ansprüche 6 bis 9, wobei die zweiten inaktiven Bereiche (NA2) so angeordnet sind, dass sie näher an dem zweiten Seitenelement (1264) und dem dritten Seitenelement (1266) liegen als an der leitenden Folie (430; 830).

11. Elektronische Vorrichtung (100; 1200) nach einem der Ansprüche 6 bis 10, wobei das zweite wasserdichte Element (824; 1224) die zweiten inaktiven Bereiche (NA2) überlappt.

12. Elektronische Vorrichtung (100; 1200) nach einem der Ansprüche 1 bis 11, wobei das erste wasserdichte Element (822; 1222) so angeordnet ist, dass es mindestens drei Flächen der Leiterplatte (420; 1202) umgibt, und
wobei das zweite wasserdichte Element (824; 1224) so angeordnet ist, dass es mindestens eine Fläche der leitenden Folie (430; 830) umgibt.

13. Elektronische Vorrichtung (100; 1200) nach einem der Ansprüche 1 bis 12, wobei das erste wasserdichte Element (822; 1222) Folgendes umfasst:
ein erstes wasserdichtes Dichtungselement, das parallel zu dem ersten Seitenelement (1262) und dem zweiten Seitenelement (1264) verläuft; und
ein zweites wasserdichtes Dichtungselement, das sich von dem ersten wasserdichten Dichtungselement zu dem dritten Seitenelement (1266) hin erstreckt,
wobei das zweite wasserdichte Element (824; 1224) Folgendes umfasst:
ein drittes wasserdichtes Dichtungselement, das parallel zum ersten wasserdichten Dichtungselement verläuft; und
ein viertes wasserdichtes Dichtungselement, das sich von dem dritten wasserdichten Dichtungselement zu dem zweiten wasserdichten Dichtungselement hin erstreckt.

14. Elektronische Vorrichtung (100; 1200) nach Anspruch 13, wobei ein Eckabschnitt des vierten wasserdichten Dichtungselements einem Eckabschnitt zugewandt ist, an dem das dritte Seitenelement (1266) und das vierte Seitenelement (1268) auf das zweite Seitenelement (1264) treffen.

15. Elektronische Vorrichtung (100; 1200) nach einem der Ansprüche 1 bis 14, wobei die leitende Folie (430; 830) eine anisotrope leitende Folie, ACF, ist.

## Revendications

1. Dispositif électronique (100 ; 1200) comprenant :
un boîtier (110 ; 1260) comprenant un premier élément latéral (1262) et un deuxième élément latéral (1264) se faisant face dans une première direction, et un troisième élément latéral (1266) et un quatrième élément latéral (1268) se faisant face dans une seconde direction différente de la première direction ;
un panneau d'affichage (401 ; 801 ; 1201) disposé dans le boîtier (110 ; 1260) ;
un film conducteur (430 ; 830) connecté au panneau d'affichage (401 ; 801 ; 1201) ;
une carte de circuit (420 ; 1202) connectée au film conducteur (430 ; 830) ;
un premier élément étanche à l'eau (822 ; 1222) espacé de la carte de circuit (420 ; 1202) ;
un second élément étanche à l'eau (824 ; 1224) faisant face au premier élément étanche à l'eau (822 ; 1222) dans la première direction, et disposé de manière à être plus proche du troisième élément latéral (1266) et du quatrième élément latéral (1268) que du film conducteur (430 ; 830) ; et
un élément de liaison étanche à l'eau (828 ; 1228) disposé entre le premier élément étanche à l'eau (822 ; 1222) et le deuxième élément étanche à l'eau (824 ; 1224), et faisant face à une surface latérale d'au moins un du film conducteur (430 ; 830) et de la carte de circuit (420 ; 1202) dans la seconde direction.

2. Dispositif électronique (100 ; 1200) de la revendication 1, dans lequel le boîtier (110 ; 1260) comprend un trou d'injection disposé dans une zone correspondant à l'élément de liaison étanche à l'eau (828 ; 1228).

3. Dispositif électronique (100 ; 1200) de la revendication 2, comprenant en outre :
un module de non-affichage logé dans le boîtier (110 ; 1260),
dans lequel le trou d'injection ne chevauche pas le module de non-affichage.

4. Dispositif électronique (100 ; 1200) de la revendication 3, dans lequel le module de non-affichage comprend au moins l'un quelconque d'une antenne, d'un ruban de couverture étanche à l'eau et d'une partie de segmentation.

5. Dispositif électronique (100 ; 1200) de l'une quelconque des revendications 2 à 4, comprenant en outre :
un premier corps magnétique (1360) logé dans le boîtier (110 ; 1260) ; et
un second corps magnétique (1350) logé dans le boîtier (110 ; 1260) pour faire face au premier corps magnétique (1360),
dans lequel le trou d'injection ne chevauche pas au moins l'un quelconque du premier corps magnétique (1360) et du second corps magnétique (1350).

6. Dispositif électronique (100 ; 1200) de l'une quelconque des revendications 1 à 5, dans lequel le panneau d'affichage (401 ; 801 ; 1201) comprend une première zone (A1), une seconde zone (A2), et une zone de pliage (BA) située entre la première zone (A1) et la seconde zone (A2),
dans lequel la seconde zone (A2) comprend :
une première zone inactive (NA1) s'étendant à partir de la zone de pliage (BA) ; et
des secondes zones inactives (NA2) s'étendant à partir des côtés opposés de la première zone inactive (NA1), et
dans lequel une largeur de la seconde zone (A2) est supérieure à une largeur de la zone de pliage (BA).

7. Dispositif électronique (100 ; 1200) de la revendication 6, dans lequel le second élément étanche à l'eau (824 ; 1224) est disposé sur des surfaces de la première zone inactive (NA1) et des secondes zones inactives (NA2).

8. Dispositif électronique (100 ; 1200) de la revendication 6 ou de la revendication 7, comprenant en outre :
un troisième élément étanche à l'eau (826) disposé sur les surfaces opposées de la première zone inactive (NA1) et de la seconde zone inactive (NA2), et
dans lequel le premier élément étanche à l'eau (822 ; 1222) est disposé entre la première zone (A1) et le boîtier (110 ; 1260),
dans lequel le deuxième élément étanche à l'eau (824 ; 1224) est disposé entre la deuxième zone (A2) et le boîtier (110 ; 1260), et
dans lequel le troisième élément étanche à l'eau (826) est disposé entre la première zone (A1) et la deuxième zone (A2).

9. Dispositif électronique (100 ; 1200) de l'une quelconque des revendications 6 à 8, dans lequel une pluralité de lignes de signal (SL) sont disposées dans au moins l'une quelconque de la première zone inactive (NA1) et de la seconde zone inactive (NA2).

10. Dispositif électronique (100 ; 1200) de l'une quelconque des revendications 6 à 9, dans lequel les secondes zones inactives (NA2) sont disposées de manière à être plus proches du second élément latéral (1264) et du troisième élément latéral (1266) que du film conducteur (430 ; 830).

11. Dispositif électronique (100 ; 1200) de l'une quelconque des revendications 6 à 10, dans lequel le second élément étanche à l'eau (824 ; 1224) chevauche les secondes zones inactives (NA2).

12. Dispositif électronique (100 ; 1200) de l'une quelconque des revendications 1 à 11, dans lequel le premier élément étanche à l'eau (822 ; 1222) est disposé de manière à entourer au moins trois surfaces de la carte de circuit (420 ; 1202), et
dans lequel le second élément étanche à l'eau (824 ; 1224) est disposé de manière à entourer au moins une surface du film conducteur (430 ; 830).

13. Dispositif électronique (100 ; 1200) de l'une quelconque des revendications 1 à 12, dans lequel le premier élément étanche à l'eau (822 ; 1222) comprend :
un premier élément d'étanchéité étanche à l'eau parallèle au premier élément latéral (1262) et au second élément latéral (1264) ; et
un second élément d'étanchéité étanche à l'eau s'étendant depuis le premier élément d'étanchéité étanche à l'eau vers le troisième élément latéral (1266),
dans lequel le deuxième élément étanche à l'eau (824 ; 1224) comprend :
un troisième élément d'étanchéité étanche à l'eau parallèle au premier élément d'étanchéité étanche à l'eau ; et
un quatrième élément d'étanchéité étanche à l'eau s'étendant depuis le troisième élément d'étanchéité étanche à l'eau vers le second élément d'étanchéité étanche à l'eau.

14. Dispositif électronique (100 ; 1200) de la revendication 13, dans lequel une partie de coin du quatrième élément d'étanchéité étanche à l'eau fait face à une partie de coin au niveau de laquelle le troisième élément latéral (1266) et le quatrième élément latéral (1268) rencontrent le deuxième élément latéral (1264).

15. Dispositif électronique (100 ; 1200) de l'une quelconque des revendications 1 à 14, dans lequel le film conducteur (430 ; 830) est un film conducteur anisotrope, ACF.
